(19) Europäisches Patentamt
European Patent Office
Office européen des brevets

(11) **EP 4 050 493 A1**

(12) **EUROPEAN PATENT APPLICATION**
published in accordance with Art. 153(4) EPC

(43) Date of publication:
**31.08.2022 Bulletin 2022/35**

(21) Application number: **20887090.7**

(22) Date of filing: **09.11.2020**

(51) International Patent Classification (IPC):
*G06F 15/78* (2006.01)

(52) Cooperative Patent Classification (CPC):
**G06F 1/26; G06F 15/78; G11C 5/14**

(86) International application number:
**PCT/CN2020/127445**

(87) International publication number:
**WO 2021/093700 (20.05.2021 Gazette 2021/20)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **14.11.2019 CN 201911114439**

(71) Applicant: **Huawei Technologies Co., Ltd.
Shenzhen, Guangdong 518129 (CN)**

(72) Inventor: **JIN, Zhigang
Shenzhen, Guangdong 518129 (CN)**

(74) Representative: **Thun, Clemens
Mitscherlich PartmbB
Patent- und Rechtsanwälte
Sonnenstraße 33
80331 München (DE)**

(54) **CIRCUIT AND ELECTRONIC DEVICE**

(57) A circuit is disclosed, including a synchronizer register and a level shifter. The synchronizer register is electrically connected to the level shifter, the level shifter is powered by a dual-rail power supply, and a high-voltage power supply in the dual-rail power supply supplies power to the synchronizer register. A metastable state elimination capability of the synchronizer register can be improved by using the circuit.

FIG. 1

## Description

### CIRCUIT AND ELECTRONIC DEVICE

This application claims priority to Chinese Patent Application No. 201911114439.6, filed with China National Intellectual Property Administration on November 14, 2019, and entitled "CIRCUIT AND ELECTRONIC DEVICE", which is incorporated herein by reference in its entirety.

### TECHNICAL FIELD

This application relates to the field of communication technologies, and in particular, to a circuit.

### BACKGROUND

With an increase in a design scale of electronic hardware and emergence of the system on chip (system on chip, SOC), a quantity of clock domain crossing signal circuits in a design of a field programmable gate array (field programmable gate array, FPGA) and an application-specific integrated circuit (application-specific integrated circuit, ASIC) increases correspondingly. As a result, a probability of a metastable state caused by clock domain crossing in the circuit also increases.

The probability of the metastable state may be reduced through sampling performed by a synchronizer register. Currently, a probability of a metastable state that occurs after the synchronizer register performs processing may be described according to a formula

$$MTBF = \frac{e^{\frac{t}{C1}}}{\alpha f C2}$$

. MTBF represents mean time between failures (mean time between failures, MTBF). t in the formula is a maximum valid metastable state resolving time period, and indicates time taken by the synchronizer register to recover from the metastable state. f is a sampling clock frequency, that is, a clock frequency of the register. $\alpha$ is a frequency at which an asynchronous event is triggered, that is, a quantity of asynchronous input changes per second. C1 and C2 are parameters of the register, which are determined by electrical characteristics of the register and can represent a register flip speed. The MTBF can be extended by increasing t or decreasing C1, C2, $\alpha$, and f, to extend an interval between two failures.

Currently, a common practice in the industry for reduction of a probability of a metastable state is to increase a value of t, that is, to increase a beat quantity of an asynchronous sampling register. However, an increase in the beat quantity of the asynchronous sampling register significantly increases a system delay and greatly affects system performance. Therefore, it is significant to improve a metastable state elimination capability of a synchronizer register.

## SUMMARY

Embodiments of this application provide a circuit, to improve a metastable state elimination capability of a synchronizer register.

To achieve the foregoing objective, embodiments of this application provide the following technical solutions.

A first aspect of this application provides a circuit. The circuit may include a synchronizer register and a level shifter. The synchronizer register is electrically connected to the level shifter, the level shifter is powered by a dual-rail power supply, and a high-voltage power supply in the dual-rail power supply supplies power to the synchronizer register. It can be learned from the first aspect that a power supply voltage of the synchronizer register can be separately increased, to further improve a metastable state elimination capability of the synchronizer register.

Optionally, with reference to the first aspect, in a first possible implementation, the circuit may include one synchronizer register and N level shifters. The synchronizer register includes N ports, each of the N ports is connected to one of the N level shifters, and level shifters connected to any two of the N ports are different, where N is a positive integer.

Optionally, with reference to the first aspect, in a second possible implementation, the circuit includes M synchronizer registers. The M synchronizer registers are connected in a cascading manner, and the high-voltage power supply in the dual-rail power supply supplies power to the M synchronizer registers.

Optionally, with reference to the second possible implementation of the first aspect, in a third possible implementation, a value of M is 2.

A second aspect of this application provides an electronic device. The electronic device includes a circuit. The circuit may include a synchronizer register and a level shifter. The synchronizer register is electrically connected to the level shifter, the level shifter is powered by a dual-rail power supply, and a high-voltage power supply in the dual-rail power supply supplies power to the synchronizer register.

Optionally, with reference to the second aspect, in a first possible implementation, the circuit may include one synchronizer register and N level shifters. The synchronizer register includes N ports, each of the N ports is connected to one of the N level shifters, and level shifters connected to any two of the N ports are different, where N is a positive integer.

Optionally, with reference to the second aspect, in a second possible implementation, the circuit includes M synchronizer registers. The M synchronizer registers are connected in a cascading manner, and the high-voltage power supply in the dual-rail power supply supplies power to the M synchronizer registers.

Optionally, with reference to the second possible implementation of the second aspect, in a third possible implementation, a value of M is 2.

Optionally, with reference to the second aspect, the first possible implementation of the second aspect, or the second possible implementation of the second aspect, in a fourth possible implementation, the electronic device may further include a peripheral logic circuit. A low voltage in the dual-rail power supply supplies power to the peripheral logic circuit. It can be learned from the fourth possible implementation of the second aspect that, when a voltage of the power supply for the peripheral logic circuit is reduced for power consumption reduction, the power supply voltage of the synchronizer register remains unchanged, so that the metastable state elimination capability of the synchronizer register is not affected.

Optionally, with reference to the second aspect, the first possible implementation of the second aspect, or the second possible implementation of the second aspect, in a fifth possible implementation, a dual-rail memory is further included. The dual-rail power supply for the level shifter is the dual-rail power supply for the memory.

In this application, the synchronizer register is powered by a separate power supply, which is different from the power supply for the peripheral logic circuit. Compared with supplying power to a synchronizer register and a peripheral logic circuit by using a same power supply, the technical solution provided in this application can further improve the metastable state elimination capability of the synchronizer register. In addition, when a voltage of the power supply for the peripheral logic circuit decreases, the power supply voltage of the synchronizer register remains unchanged, that is, a voltage of a second power supply remains unchanged, so that the metastable state elimination capability of the synchronizer register is not affected.

## BRIEF DESCRIPTION OF DRAWINGS

FIG. 1 is a schematic diagram of a structure of a circuit according to this application;
FIG. 2 is a schematic diagram of a structure of another circuit according to this application; and
FIG. 3 is a schematic diagram of a structure of an electronic device according to this application.

## DESCRIPTION OF EMBODIMENTS

Embodiments of this application provide a circuit, to improve a metastable state elimination capability of a synchronizer register. Embodiments of this application further provide a corresponding electronic device. Detailed descriptions are provided separately below.

The following clearly and completely describes the technical solutions in embodiments of this application with reference to the accompanying drawings in embodiments of this application. It is clear that the described embodiments are merely some but not all of embodiments of this application. All other embodiments obtained by a person skilled in the art based on embodiments of this application without creative efforts shall fall within the protection scope of this application.

With an increase in a design scale of electronic hardware and emergence of a system on chip (system on chip, SOC), a quantity of clock domain crossing signal circuits in a design of a field programmable gate array (field programmable gate array, FPGA) and an application-specific integrated circuit (application-specific integrated circuit, ASIC) increases correspondingly. As a result, a probability of a metastable state caused by clock domain crossing in the circuit also increases. Clock domain crossing is sometimes referred to as clock domain asynchronization in this application. When a signal is transferred between clock domains, a probability of a metastable state may be reduced by using synchronizer register sampling. Currently, a probability of a metastable state after synchronizer register processing may be described with a following formula:

$$MTBF = \frac{e^{\frac{t}{C1}}}{\alpha f C2}$$

MTBF represents mean time between failures (mean time between failures, MTBF). t in the formula is a maximum valid metastable state resolving time period, and indicates time taken by the synchronizer register to recover from the metastable state. f is a clock sampling frequency, that is, a clock frequency of the register. $\alpha$ is a frequency at which an asynchronous event is triggered, that is, a quantity of asynchronous input changes per second. C1 and C2 are parameters of the register, which are determined by electrical characteristics of the register and can represent a register flip speed. The MTBF can be extended by increasing t or decreasing C1, C2, $\alpha$, and f, to extend an interval between two failures. Currently, a common practice in the industry for reduction of a probability of a metastable state is to increase a value of t, that is, to increase a beat quantity of an asynchronous sampling register. However, an increase in the beat quantity of the asynchronous sampling register significantly increases a system delay and greatly affects system performance. Therefore, it is significant to improve a metastable state elimination capability of a synchronizer register.

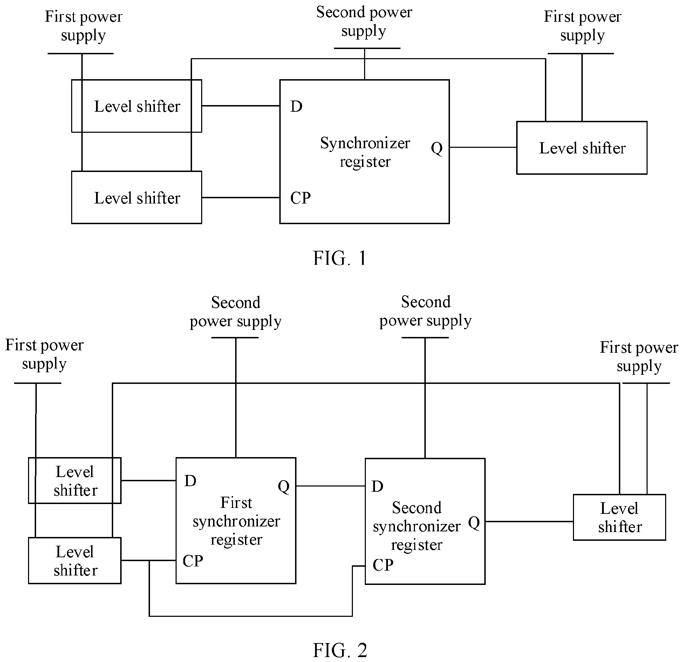

FIG. 1 is a schematic diagram of a structure of a circuit according to this application. As shown in FIG. 1, the circuit includes one synchronizer register and N level shifters (level shifter). The synchronizer register includes N ports, where N is a positive integer. Any one of the N level shifters includes two ports, where one of the two ports is connected to any one of the N ports of the synchronizer register, and the other port is connected to a first power supply. The synchronizer register is powered by a second power supply. In other words, each of the N ports of the synchronizer register is connected to one level shifter, the second power supply supplies power to the synchronizer register, and the level shifter is powered by a dual-rail power supply, that is, the level shifter supports dual-rail power supply. The power supply for the level shifter includes the first power supply and the second power supply. The first power supply supplies power to a peripheral logic circuit, and the peripheral logic circuit is a circuit other than the foregoing circuit in a device including the foregoing circuit. The second power supply supplies power to the synchronizer register. A higher voltage indicates a smaller value of C1. Therefore, in a specific implementation, the second power supply has a high voltage, and the first power supply has a low voltage. In the specification, claims, and accompanying drawings of this application, the terms "first", "second", and the like are intended to distinguish between similar objects but do not represent a limitation on the solutions.

It should be noted that a quantity of ports included in the synchronizer register is not limited in embodiments of this application. As shown in FIG. 1, the synchronizer register includes three ports: an input port D, an output port Q, and a clock port CP. The three ports are merely examples for description, and this does not represent a limitation on the quantity of the ports included in the synchronizer register.

It can be learned, from the structure of the circuit shown in FIG. 1, that the synchronizer register is powered by a separate power supply, which is different from the power supply for the peripheral logic circuit. That a synchronizer register and a peripheral logic circuit are powered by a same power supply may have the following disadvantages: For example, in many designs, a voltage is reduced for power consumption reduction. However, reducing the voltage increases a value of C1 of the synchronizer register. According to the foregoing description, an increase in the value of C1 weakens the metastable state elimination capability of the synchronizer register. In addition, for another example, a quantity of phase inverters on a feedback path in the synchronizer register may usually be increased to improve the metastable state elimination capability of the synchronizer register. However, when a voltage of the power supply for the synchronizer register and the peripheral logic circuit is determined, only an increase in a quantity of phase inverters on the feedback path of the synchronizer register gradually decreases the impact on improvement of the metastable state elimination capability of the synchronizer register. The disadvantage that may exist when a synchronizer register and a peripheral logic circuit are powered by the same power supply can be resolved by using the circuit structure shown in FIG. 1. A supply voltage of the synchronizer register can be increased separately, that is, a voltage of the second power supply can be increased by using the circuit structure shown in FIG. 1. Compared with a solution in which the synchronizer register and the peripheral logic circuit are powered by the same power supply, this solution may further improve the metastable state elimination capability of the synchronizer register. In addition, when a voltage of the power supply for the peripheral logic circuit decreases, that is, when a voltage of the first power supply mentioned above decreases, the power supply voltage of the synchronizer register may remain unchanged, that is, the voltage of the second power supply remains unchanged, so that the metastable state elimination capability of the synchronizer register is not affected.

The circuit shown in FIG. 1 includes only one synchronizer register. In a specific implementation, the circuit may include a plurality of synchronizer registers. FIG. 2 is a schematic diagram of a structure of another circuit according to this application. A quantity of synchronizer registers in the circuit may be increased to further reduce a probability of a metastable state. A quantity of synchronizer registers that may be included in the circuit is not limited in this embodiment of this application. As shown in FIG. 2, an example in which the circuit includes two synchronizer registers is used for description. The two synchronizer registers are connected in a cascading manner. Cascading means that an output of one synchronizer register is used as an input for the other synchronizer register. As shown in FIG. 2, a first synchronizer register and a second synchronizer register are connected in a cascading manner, and each of other ports of the first synchronizer and the second synchronizer is connected to one circuit shifter. The other ports herein are ports of the synchronizer register other than a port for cascading connection. Each circuit shifter in the circuit supports dual-rail power supply. Cascaded synchronizer registers are powered by a same power supply. A power supply for a peripheral logic circuit is different from the power supply for the synchronizer register. Peripheral logic circuits are powered by a same power supply.

In a specific implementation, this application further provides an electronic device. The electronic device includes the circuit described above.

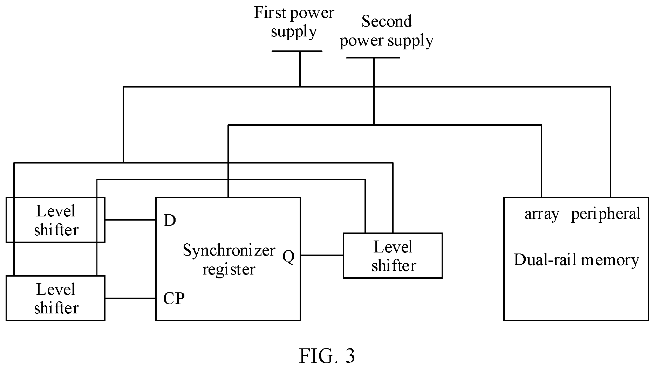

In a specific implementation, the electronic device further includes a dual-rail memory. A dual-rail memory is currently a typical design scheme of a memory. When a device includes both a dual-rail memory and a synchronizer register, a dual-rail power supply supported by a level shifter is the dual-rail power supply for the dual-rail memory. A high-voltage power supply in the dual-rail memory may supply power to the synchronizer register. When a voltage of the high-voltage power supply is increased, the metastable state elimination capability of the synchronizer register can be improved. As shown in FIG. 3, an example in which a circuit includes one synchronizer register is used for description. If a power supply for a memory cell array (array) is a high-voltage power supply in a dual-rail memory, and a power supply for a peripheral circuit (peripheral) of the memory is a low-voltage power supply in the dual-rail memory, the power supply for the array supplies power to the synchronizer register, and the power supply for the peripheral supplies power to a peripheral logic circuit. The peripheral logic circuit herein is a circuit in the electronic device other than the synchronizer register and the dual-rail memory. In addition to supplying power to the synchronizer register by using the high-voltage power supply in the dual-rail memory listed in this implementation, there are other manners. For example, a high-voltage power supply is needed only in the design to supply power to the synchronizer register. Alternatively, the power supply is connected to a high-voltage power supply for the synchronizer register, to improve the metastable state elimination capability of the synchronizer register.

The circuit and the electronic device provided in embodiments of the present invention are described in detail above. The principles and implementations of the present invention are described herein by using specific examples. The description about the foregoing embodiments is merely provided to help understand the methods and core ideas of this application. In addition, a person of ordinary skill in the art can make modifications to the specific implementations and application scopes according to the ideas of this application. In conclusion, content of this specification shall not be construed as a limitation on this application.

**Claims**

1. A circuit, comprising: a synchronizer register and a level shifter, wherein the synchronizer register is electrically connected to the level shifter, the level shifter is powered by a dual-rail power supply, and a high-voltage power supply in the dual-rail power supply supplies power to the synchronizer register.

2. The circuit according to claim 1, wherein the circuit comprises one synchronizer register and N level shifters, the synchronizer register comprises N ports, each of the N ports is connected to one of the N level shifters, and level shifters connected to any two of the N ports are different, wherein N is a positive integer.

3. The circuit according to claim 1, wherein the circuit comprises M synchronizer registers, the M synchronizer registers are connected in a cascading manner, and the high-voltage power supply in the dual-rail power supply supplies power to the M synchronizer registers, wherein M is a positive integer.

4. The circuit according to claim 3, wherein M is 2.

5. An electronic device, wherein the electronic device comprises a circuit, the circuit comprises a synchronizer register and a level shifter, the synchronizer register is electrically connected to the level shifter, the level shifter is powered by a dual-rail power supply, and a high-voltage power supply in the dual-rail power supply supplies power to the synchronizer register.

6. The electronic device according to claim 5, wherein the circuit comprises one synchronizer register and N level shifters, the synchronizer register comprises N ports, each of the N ports is connected to one of the N level shifters, and level shifters connected to any two of the N ports are different, wherein N is a positive integer.

7. The electronic device according to claim 5, wherein the circuit comprises M synchronizer registers, the M synchronizer registers are connected in a cascading manner, and the high-voltage power supply in the dual-rail power supply supplies power to the M synchronizer registers, wherein M is a positive integer.

8. The electronic device according to claim 7, wherein M is 2.

9. The electronic device according to any one of claims 5 to 7, further comprising a peripheral logic circuit, wherein a low voltage in the dual-rail power supply supplies power to the peripheral logic circuit.

10. The electronic device according to any one of claims 5 to 7, further comprising a dual-rail memory, wherein the dual-rail power supply for the level shifter is the dual-rail power supply for the memory.

First power supply

Second power supply

First power supply

Level shifter → D

Synchronizer register Q → Level shifter

Level shifter → CP

FIG. 1

First power supply

Second power supply

Second power supply

First power supply

Level shifter → D

First synchronizer register Q → D

Second synchronizer register Q → Level shifter

Level shifter → CP

CP

FIG. 2

First power supply

Second power supply

Level shifter

Level shifter

Synchronizer register

D

CP

Q

Level shifter

array peripheral

Dual-rail memory

FIG. 3

## INTERNATIONAL SEARCH REPORT

| International application No. |
| --- |
| **PCT/CN2020/127445** |

### A. CLASSIFICATION OF SUBJECT MATTER

G06F 15/78(2006.01)i

According to International Patent Classification (IPC) or to both national classification and IPC

### B. FIELDS SEARCHED

Minimum documentation searched (classification system followed by classification symbols)

G06F;H04L;G01D

Documentation searched other than minimum documentation to the extent that such documents are included in the fields searched

Electronic data base consulted during the international search (name of data base and, where practicable, search terms used)

CNPAT, CNKI, EPODOC, WPI: 同步, 寄存器, 亚稳态, 压稳状态, 电平, 转换, 双电源, 高电压, 高压, 低压, 低电压, 供电, synchronous, register, metastable, level, switch, conversion, double, high, low, voltage, supply, power

### C. DOCUMENTS CONSIDERED TO BE RELEVANT

| Category* | Citation of document, with indication, where appropriate, of the relevant passages | Relevant to claim No. |
| --- | --- | --- |
| A | CN 105191205 A (ORACLE INTERNATIONAL CORPORATION) 23 December 2015 (2015-12-23) description, paragraphs [0019]-[0069], and figures 1-8 | 1-10 |
| A | CN 106595724 A (INSTITUTE OF AUTOMATION, CHINESE ACADEMY OF SCIENCES) 26 April 2017 (2017-04-26) entire document | 1-10 |
| A | CN 106462553 A (UNIVERSITY OF SOUTHERN CALIFORNIA) 22 February 2017 (2017-02-22) entire document | 1-10 |
| A | CN 103514134 A (LANGCHAO ELECTRONIC INFORMATION INDUSTRY CO., LTD.) 15 January 2014 (2014-01-15) entire document | 1-10 |
| A | CN 104407997 A (NATIONAL UNIVERSITY OF DEFENSE TECHNOLOGY, PLA) 11 March 2015 (2015-03-11) entire document | 1-10 |
| A | FR 3055712 A1 (COMMISSARIAT ENERGIE ATOMIQUE) 09 March 2018 (2018-03-09) entire document | 1-10 |

☐ Further documents are listed in the continuation of Box C.　　☑ See patent family annex.

| \* | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **28 January 2021** | **10 February 2021** |

| Name and mailing address of the ISA/CN | Authorized officer |
| --- | --- |
| **China National Intellectual Property Administration (ISA/CN) No. 6, Xitucheng Road, Jimenqiao, Haidian District, Beijing 100088 China** | |
| Facsimile No. **(86-10)62019451** | Telephone No. |

Form PCT/ISA/210 (second sheet) (January 2015)

**INTERNATIONAL SEARCH REPORT**
Information on patent family members

International application No.

**PCT/CN2020/127445**

| Patent document cited in search report | | | Publication date (day/month/year) | Patent family member(s) | | | Publication date (day/month/year) |
|---|---|---|---|---|---|---|---|
| CN | 105191205 | A | 23 December 2015 | EP | 2951943 | A1 | 09 December 2015 |
| | | | | JP | 6397829 | B2 | 26 September 2018 |
| | | | | CN | 105191205 | B | 18 January 2019 |
| | | | | JP | 2016509810 | A | 31 March 2016 |
| | | | | US | 9509317 | B2 | 29 November 2016 |
| | | | | WO | 2014121057 | A1 | 07 August 2014 |
| | | | | US | 2014210526 | A1 | 31 July 2014 |
| CN | 106595724 | A | 26 April 2017 | CN | 106595724 | B | 30 July 2019 |
| CN | 106462553 | A | 22 February 2017 | US | 9875327 | B2 | 23 January 2018 |
| | | | | KR | 20170005437 | A | 13 January 2017 |
| | | | | US | 2016154905 | A1 | 02 June 2016 |
| | | | | US | 9558309 | B2 | 31 January 2017 |
| | | | | WO | 2015171496 | A1 | 12 November 2015 |
| | | | | US | 2015326210 | A1 | 12 November 2015 |
| CN | 103514134 | A | 15 January 2014 | CN | 103514134 | B | 15 February 2017 |
| CN | 104407997 | A | 11 March 2015 | CN | 104407997 | B | 19 September 2017 |
| FR | 3055712 | A1 | 09 March 2018 | FR | 3055712 | B1 | 28 September 2018 |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 201911114439